# EUROPÄISCHE PATENTSCHRIFT

(11) **EP 2 856 186 B1**
(45) Veröffentlichungstag und Bekanntmachung des Hinweises auf die Patenterteilung: **14.09.2016**
(21) Anmeldenummer: 13723416.7
(22) Anmeldetag: 17.05.2013
(51) Int. Cl.: G01R 31/36

(54) **VERFAHREN UND VORRICHTUNG ZUM FESTSTELLEN DER TATSÄCHLICHEN KAPAZITÄT EINER BATTERIE**
METHOD AND DEVICE FOR DETERMINING THE ACTUAL CAPACITY OF A BATTERY
PROCÉDÉ ET DISPOSITIF POUR DÉTERMINER LA CAPACITÉ RÉELLE D'UNE BATTERIE

(30) Priorität: 26.05.2012 DE 102012010486
(43) Veröffentlichungstag der Anmeldung: 08.04.2015
(73) Patentinhaber: Audi AG, 85045 Ingolstadt (DE)
(72) Erfinder: BARKE, Alexander, 85049 Ingolstadt (DE); NAUMANN, Rolf, 96247 Michelau (DE)
(74) Vertreter: Herbst, Matthias Heinz
(86) Internationale Anmeldenummer: PCT/EP2013/001484
(87) Internationale Veröffentlichungsnummer: WO 2013/178330

(56) Entgegenhaltungen:
- EP-A1- 1 111 705
- EP-A2- 0 410 716

## Beschreibung

Die vorliegende Erfindung betrifft ein Verfahren und eine Vorrichtung zum Bewerten eines Alterungszustands einer Batterie unter Verwendung einer Batteriekennlinie.

In einem Kraftfahrzeug, bei dem eine Batterie (= wiederaufladbare elektrische Energiequelle; Sekundärbatterie bzw. Akkumulator) als alleinige oder neben einer Verbrennungskraftmaschine als weitere Energiequelle zum Antrieb des Fahrzeugs Verwendung findet (Elektrofahrzeug, Hybrid-Fahrzeug), kommt der Kapazität der Batterie eine wichtige Rolle für die Reichweite des Kraftfahrzeugs zu, die dieses ohne erneute Aufladung der Batterie zurücklegen kann.

Es ist eine bekannte Tatsache, dass sich die entnehmbare Energiemenge, d. h. entnehmbare Strommenge beispielsweise eines derzeit erhältlichen Lithiumionen-Akkumulators mit zunehmendem Alter und/oder Anzahl an Lade- und Entladezyklen verringert.

Dieser Kapazitätsverlust, der umgangssprachlich allgemein als Alterung bezeichnet wird und eine Ausprägung der Änderung des Verhaltens von Batterien im Lade- und Entladebetrieb (bestimmungsgemäßer Einsatz) oder durch kalendarische Alterung ist, kann derzeit nur unzureichend bestimmt werden.

Die bekannten Verfahren zur Bestimmung des Kapazitätsverlusts sind entweder sehr komplex und/oder schwer parametrierbar (z. B. bei Impedanzermittlungen) oder verwendete Alterungsmodelle sind nicht vollständig bzw. ausreichend parametriert und das kann zu erheblichen Abweichungen in der Berechnung führen.

Einfache Verfahren haben meist den Nachteil, dass wichtige Parameter nicht berücksichtigt werden können oder auch einfach nicht bekannt sind (z. B. die Verlustleistung bzw. ein Wirkungsgrad, der über die Lebensdauer und den Einsatz der Batterien nicht konstant zu sein braucht).

Eine dedizierte Aussage über den aktuellen Energieinhalt, also die tatsächlich verfügbare Strommenge, kann im laufenden bzw. normalen Betrieb daher nicht einfach gemacht werden. Da die Batteriekapazität sich durch die Ausprägung von Alterung reduziert, werden aber bei nicht richtig nachgeführter tatsächlicher (bzw. korrigierter) Batteriekapazität Aussagen über Verfügbarkeiten fehlschlagen bzw. ungenau sein.

Viele der bekannten Verfahren zur Bestimmung der aktuellen Kapazität einer Batterie erfordern die Ermittlung von Ladungszuständen (State of Charge, SOC) der Batterie, die auf Messungen von Ruhespannungen (Open Circuit Voltage, OCV) der Batterien basieren, sowie der Messung der zwischen zwei Ladungszuständen entnommenen Strommenge.

So beschreibt beispielsweise die EP 1 314 992 A2 eine Vorrichtung und ein Verfahren zum Bestimmen der Kapazität eines zum Antrieb eines Elektroautos bestimmten Akkumulators, bei dem über die jeweiligen Ruhespannungen im lastfreien Zustand ein erster Ladungszustand des Akkumulators und ein zweiter Ladungszustand des Akkumulators ermittelt werden, und aus der zwischen den zwei Ladungszuständen geflossenen Entlade-Strommenge die tatsächliche Kapazität des Akkumulators bestimmt wird.

Aus der DE 10 2007 037 041 A1 ist ein Verfahren und eine Vorrichtung zur Batteriezustandserkennung einer Säure-Batterie unter Verwendung eines abgespeicherten Batteriemodells bekannt. Dabei wird die Ruhespannung der Säure-Batterie in Abhängigkeit von der der Batterie entnehmbaren Ladung in Form einer Kennlinie hinterlegt. Es erfolgt eine Ermittlung eines ersten Parameters, der den durch die Alterung der Batterie und eine Säureschichtung der Batterie verursachten Kapazitätsverlust der Batterie beschreibt. Weiterhin wird ein zweiter Parameter ermittelt, der Auskunft über die Steigung der Kennlinie gibt. Ferner erfolgt eine Adaption der gespeicherten Kennlinie unter Berücksichtigung des ersten und des zweiten Parameters.

Gemäß dieser Druckschrift erfolgt die Ermittlung der entnehmbaren Energiemenge und der tatsächlichen Kapazität einer Säure-Batterie durch Ermittlung einer Ruhespannungs-Amperestunden-Kennlinie. Im Vergleich zu einer neuen Batterie ohne Säureschichtung ist bei einer gealterten Batterie die Kennlinie parallel nach oben verschoben, und bei einer Batterie mit Säureschichtung weist die Kennlinie eine vergrößerte Steigung auf. Die Ruhespannungs-Amperestunden-Kennlinie kann durch Messung der Batterie-Ruhespannung vor und nach einer Entladung erfasst werden. Eine Adaption der gespeicherten Kennlinie erfolgt dann unter Verwendung der tatsächlich ermittelten Spannungs-Amperestunden-Kennlinie.

Die DE 10 2010 006 965 A1 beschreibt ein Verfahren zur Bestimmung wenigstens eines Bereichs einer Batteriekennlinie für eine Batterie in einem Fahrzeug wobei der aktuelle Ladungszustand der Batterie aus gemessenen Batterieparametern bestimmt wird, ein Verschiebungswert aus der Differenz eines gemessenen Batterieparameters und eines Standard-Werts, welcher aus einer Standard-Batteriekennlinie unter Berücksichtigung des bestimmten Landungszustands ermittelt wird, bestimmt wird, und wenigstens ein Bereich einer neuen Batteriekennlinie durch Addition des Verschiebungswertes zu der Standard-Batteriekennlinie ermittelt wird.

Gemäß dieser Druckschrift erfolgt eine Bestimmung der aktuellen Batteriekennlinie durch Messung von Leerlaufspannungen nach einer längeren Ruhephase der Batterie bei verschiedenen Ladungszuständen einer Batterie. Die Abweichung der aktuellen Batteriekennlinie (Leerlaufspannung-aktueller Ladungszustand-Kennlinie) von der Batteriekennlinie einer "Standard-Batterie" wird aufgrund eines Vergleichs der jeweiligen Ruhespannungen bei gegebenen Ladungszuständen bzw. aufgrund eines Vergleichs von jeweiligen Ladungszuständen bei gegebenen Ruhespannungen ermittelt.

Aus der JP 2002-243 813 A ist eine Recheneinheit bekannt, die eine Veränderung des Ladungszustandes eines Akkumulators aus dem über die Zeit integrierten Entladestrom des Akkumulators auf Grundlage der Leerlaufspannungen am Integrationsstartzeitpunkt und am Integrationsendzeitpunkt, sowie die Korrelation zwischen den Leerlaufspannungen und dem Ladungszustand des Akkumulators berechnet. Weiter berechnet die Recheneinheit die mit der Zeit eingetretene verschlechterte Kapazität des Akkumulators auf Grundlage eines integrierten Entladestromwerts, der auf Grundlage des Entladestroms und der Veränderung des Ladungszustands berechnet wird. Darüber hinaus berechnet die Recheneinheit die Kapazitäts-Verschlechterungs-Rate auf Grundlage der mit der Zeit eingetretenen verschlechterten Kapazität und der anfänglichen Kapazität des Akkumulators.

Wie aus dieser kurzen Übersicht zu entnehmen ist, ist bei allen oben beschriebenen Verfahren und Vorrichtungen die Messung eine Ruhespannung (Open Circuit Voltage, OCV) der Batterie erforderlich. Diese Ruhespannung kann mit hinreichender Genauigkeit jedoch nur gemessen werden, wenn nach dem Ende eines Entladevorgangs eine nicht unbeträchtliche Zeitdauer vergangen ist. So ist beispielsweise aus Fig. 6 von EP 1 314 992 A2 entnehmbar, dass eine Ruhephase von bis zu 3000 Sekunden, also von bis zu 50 Minuten erforderlich sein kann, bis die Spannung nach der Beendigung eines Entladevorgangs einen stabilen Wert angenommen hat.

Aus der EP 0 410 716 A2 ist eine Stromversorgung bekannt, die von einer externen Stromquelle,und einer Batterie mit Energie versorgt wird, und elektrische Leistung an eine Last liefert. Die Stromversorgung enthält einen Batteriespannungsdetektor und einen Stromdetektor zum Erfassen eines Entladestroms der Batterie. Die verbleibende Kapazität der Batterie wird in Übereinstimmung mit einer Änderung der Batteriespannung ermittelt, wenn die externe Energiequelle keinen Stromausfall aufweist. Die Änderung der Batteriespannung ist definiert als die Differenz zwischen einer anfänglichen Spannung der Batterie und einer aktiven Spannung, die erhalten wird, wenn die Batterie durch den erfassten Entladestrom für eine vorbestimmte Zeitdauer entladen wird.

Und die EP 1 111 705 A1 beschreibt ein Verfahren zum Nachweis einer Verschlechterung einer elektrochemischen Vorrichtung, die Elektroden und einen Ionenleiter aufweist. Gemäß dieser Offenlegungsschrift werden Batterien mit einem konstanten elektrischen Strom geladen, bis eine vorgegebene erste Spannung erreicht ist. Die Restkapazität der Batterien in diesem Zustand wird als 100% definiert. Die Batterien werden danach für eine Woche, zwei Wochen, drei Wochen oder einen Monat bei 85°C gelagert. Nach der Lagerung bei hoher Temperatur wird jede Batterie mit einem konstanten Strom bei einer konstanten Temperatur entladen, bis die Spannung auf eine zweite vorgegebene Spannung abgesunken ist. Es wurde herausgefunden, dass die Batteriekapazität umso kleiner ist, je länger die Batterie bei der hohen Temperatur gelagert wurde, wodurch das Fortschreiten der Verschlechterung aufgrund Lagerung bei einer hohen Temperatur nachgewiesen wurde.

Es ist Aufgabe der vorliegenden Erfindung, ein Verfahren und eine Vorrichtung zum Feststellen der tatsächlichen Kapazität einer Batterie zur Verfügung zu stellen, durch die die Nachteile des Stands der Technik überwunden werden.

Diese Aufgabe wird gelöst und weitere Vorteile werden erzielt durch das Verfahren gemäß Anspruch 1 und die Vorrichtung gemäß Anspruch 8 Vorteilhafte Weiterbildungen der Erfindung sind Gegenstand der Unteransprüche. Das erfindungsgemäße Verfahren zum Feststellen der tatsächlichen Kapazität einer Batterie im laufenden Betrieb erfolgt unter Verwendung eines Kennlinienfelds, deren Kennlinien unter Berücksichtigung der Entladestromstärke, der Temperatur und der entnehmbaren Kapazität der Batterie generiert oder erzeugt werden, wobei am Anfang eines Entladevorgangs die Anfangsspannung U_{Beginn} der Batterie, die Entladestromstärke und die Temperatur der Batterie ermittelt werden, hieraus durch Vergleich mit den im Kennlinienfeld vorhandenen Daten eine Kennlinie ausgewählt und ein Anfangszustand der Batterie festgelegt werden. Am Ende des Entladevorgangs werden die Schlussspannung U_{Mess} der Batterie gemessen und diese Schlussspannung U_{Mess} mit der aufgrund der gewählten Kennlinie erwarteten Spannung U_{Erwartet} am Ende der Entladung verglichen und es wird für den Fall, dass die Schlussspannung U_{Mess} kleiner als die aufgrund des Entladevorgangs erwartete Spannung U_{Erwartet} ist, festgestellt, dass die tatsächliche Kapazität der Batterie kleiner ist als die am Anfang des Entladevorgangs angenommene entnehmbare Kapazität.

Das erfindungsgemäße Verfahren zeichnet sich dadurch aus, dass zur Bewertung des Alterungszustands einer Batterie keine Ruhespannung (Open Circuit Votage, OCV) gemessen werden muss, das Verfahren bei normalen Einsatzzwecken verwendbar ist, einfach anzuwenden ist, da es keine speziellen Testmodi oder -prozeduren benötigt, und nicht auf komplizierten Parametern und/oder Modellen beruht. Durch das erfindungsgemäße Verfahren kann somit im laufenden Betrieb auf einfache Weise eine dedizierte Aussage über den aktuellen Energieinhalt einer Batterie gemacht werden. Aufgrund der durch das erfindungsgemäße Verfahren richtig nachgeführten tatsächlichen bzw. korrigierten Batteriekapazität ist auch eine genaue Aussage über die tatsächlich verfügbare Strommenge einer Batterie möglich.

Gemäß einer vorteilhaften Weiterbildung der Erfindung erfolgt bei dem erfindungsgemäßen Verfahren die Feststellung der tatsächlichen Kapazität der Batterie, indem die oben beschriebenen Schritte in der angegebenen Reihefolge mehrere Male in Folge wiederholt und eine Bewertung der ermittelten Differenz zwischen der Schlussspannung U_{Mess} und der erwarteten Spannung U_{Erwartet} durchgeführt werden.

Ebenso ist es vorteilhaft, wenn beim erfindungsgemäßen Verfahren die Feststellung der tatsächlichen Kapazität der Batterie erfolgt, nachdem die oben beschriebenen Schritte wenigstens 5 Mal in Folge durchgeführt wurden.

Zur Feststellung der tatsächlichen Kapazität kann vorteilhafter Weise beispielsweise wie folgt vorgegangen werden: In einem zweidimensionalen Koordinatensystem werden die Anfangsspannung U_{Beginn} und die Schlussspannung U_{Mess} der Batterie gegen die Zeit in Abhängigkeit von der entnommenen Ladungsmenge, sowie die erwartete Spannung U_{Erwartet} gegen die Zeit in Abhängigkeit von der entnommenen Ladungsmenge eingetragen, die Steigung der Verbindungslinie zwischen der Anfangsspannung U_{Beginn} und der Schlussspannung U_{Mess}, sowie die Steigung der Verbindungslinie zwischen der Anfangsspannung U_{Beginn} und der erwarteten Spannung U_{Erwartet} ermittelt, und hieraus die Differenz der Steigungen der Verbindungslinien oder der Winkel zwischen den Verbindungslinien ermittelt. Diese ermittelten Werte können dann zur Bewertung des Alterungszustands der Batterie und/oder zur Feststellung der tatsächlichen Kapazität herangezogen werden.

Selbstverständlich kann und wird in der Praxis das gerade beschriebene Verfahren - so wie alle anderen hier offenbarten Verfahren auch - unter Zuhilfenahme einer Recheneinheit und entsprechender digitaler bzw. digitalisierter Daten durchgeführt werden.

Da die Feststellung einer verringerten tatsächlichen Kapazität einer Batterie zum Beispiel für das Energiemanagement eines Elektrofahrzeugs oder Hybrid-Fahrzeugs von eminenter Wichtigkeit ist, und die tatsächliche Kapazität beispielsweise für eine Reichweitenvoraussage verwendet wird, ist es gemäß einer weiteren vorteilhaften Weiterbildung der Erfindung vorgesehen, dass für den Fall, dass die Bewertung des Alterungszustands eine im Vergleich zu einer neuwertigen Batterie verringerte tatsächliche Kapazität ergeben hat, eine verringerte nominale, entnehmbare, verfügbare und/oder tatsächliche Kapazität in einer Speichereinrichtung gespeichert wird/werden.

Diese(r) gespeicherte(n) Wert(e) stehen dann beispielsweise anderen Einrichtungen für weitere Berechnungen und/oder Bewertungen zur Verfügung und können beispielsweise aus der Speichereinrichtung ausgelesen werden.

Für den Fall, dass die Bewertung des Alterungszustands eine im Vergleich zu einer neuwertigen Batterie verringerte tatsächliche Kapazität ergeben hat, wird/werden in vorteilhafter Weise bei einem durch eine mathematische Formel beschriebenen Kennlinienfeld und/oder bei einer durch eine mathematische Formel beschriebenen Kennlinie die Größe der nominalen, entnehmbaren und/oder verfügbaren Kapazität um ein vorgebbaren Wert zurückgenommen.

Aus Gründen der Systemstabilität ist es von Vorteil, wenn die ermittelte Änderung der tatsächlichen Kapazität nicht voll angerechnet wird, sondern nur eine Adaption in die entsprechende Änderungsrichtung beschrieben wird. Daher ist vorteilhaft, wenn die ermittelte Verringerung der tatsächlichen Kapazität nicht im vollem Umfang für die Bestimmung der nominalen, entnehmbaren und/oder verfügbaren Kapazität verwendet wird.

Die vorliegende Erfindung umfasst auch eine Vorrichtung zum Feststellen der tatsächlichen Kapazität einer Batterie im laufenden Betrieb mit einer Speichereinrichtung, einer Spannungsmesseinrichtung, einer Strommesseinrichtung, einer Temperaturmesseinrichtung und einer Recheneinheit und einem darin ausführbaren Computerprogramm, wobei die Speichereinrichtung dazu eingerichtet ist, wenigstens ein Kennlinienfeld einer Batterie zu speichern bzw. darin gespeichert zu haben, wobei die Kennlinien des Kennlinienfelds unter Berücksichtigung der Entladestromstärke, der Temperatur und der entnehmbaren Kapazität der Batterie generiert oder erzeugt wurden, die Spannungsmesseinrichtung dazu eingerichtet ist, wenigstens eine Anfangsspannung U_{Beginn} der Batterie am Anfang und eine Schlussspannung U_{Mess} der Batterie am Ende eines Entladevorgangs zu messen, die Strommesseinrichtung dazu eingerichtet ist, wenigstens die Stärke eines Entladestroms der Batterie zu messen, die Temperaturmesseinrichtung dazu eingerichtet ist, die Temperatur von wenigstens einer Batteriekomponente zu messen, und die Recheneinheit mit dem darauf ablaufenden Computerprogramm dazu eingerichtet ist, unter Berücksichtigung der Anfangsspannung U_{Beginn}, der Schlussspannung U_{Mess} und der aufgrund der gewählten Kennlinie erwarteten Spannung U_{Erwartet} die tatsächliche Kapazität der Batterie festzustellen, derart, dass für den Fall, dass die Schlussspannung U_{Mess} kleiner als die aufgrund des Entladevorgangs erwartete Spannung U_{Erwartet} ist, festgestellt wird, dass die tatsächliche Kapazität der Batterie kleiner ist als die am Anfang des Entladevorgangs angenommene entnehmbare Kapazität.

Die erfindungsgemäße Vorrichtung ist weiter dazu eingerichtet, ein jedes der oben beschriebenen Verfahren durchführen zu können. Eine Ausgestaltung der erfindungsgemäßen Vorrichtung derart, dass sie zur Durchführung aller erfindungsgemäßen Verfahren geeignet ist, ist Fachleuten aufgrund ihrer Kenntnisse bekannt bzw. kann durch einige wenige Versuche leicht ermittelt werden.

Die vorliegende Erfindung wird anhand der beigefügten Zeichnungen näher erläutert.

Dabei zeigen:
- Fig. 1:: Ein Diagramm mit einigen in einem Kennfeld einer Batterie hinterlegten Kennlinien;
- Fig. 2:: Ein Diagramm mit dem tatsächlichen Verlauf der Spannung einer Batterie aufgetragen gegen die Zeit in Abhängigkeit von der entnommenen Ladungsmenge und dem entsprechenden erwarteten Verlauf der Spannung aufgrund der ausgewählten Kennlinie;
- Fig. 3:: Ein ähnliches Diagramm wie in Fig. 2, jedoch mit eingetragenen Verbindungsgeraden zwischen U_{Beginn} und U_{Mess} sowie U_{Beginn} und U_{Erwartet}.

Die Darstellungen in den Figuren sind rein schematisch und nicht maßstabsgerecht.

Die nachfolgend erläuterten Ausführungsbeispiele stellen bevorzugte Ausführungsformen der vorliegenden Erfindung dar. Die vorliegende Erfindung ist selbstverständlich nicht auf diese Ausführungsformen beschränkt.

In der nachfolgenden Beschreibung haben die folgenden Begriffe die jeweils angegebene Bedeutung:
- Nominale Kapazität:: Die gemäß Angabe des Herstellers entnehmbare Strommenge, normiert auf eine Standard-Temperatur und einen Referenzstrom (wird auch als Nennkapazität bezeichnet);
- Entnehmbare Kapazität:: die je nach Batterie-/Akkumulator-Technologie unterschiedlich große, tatsächlich entnehmbare Strommenge in Abhängigkeit von der Temperatur und der Stromstärke;
- Verfügbare Kapazität:: gemessene Kapazität bei Standard-Temperatur und Referenzstromstärke; wird zur Bewertung der Abweichung von der nominalen Kapazität verwendet;
- Tatsächliche Kapazität:: tatsächlich entnehmbare Kapazität in Abhängigkeit von der Temperatur und der Stromstärke;

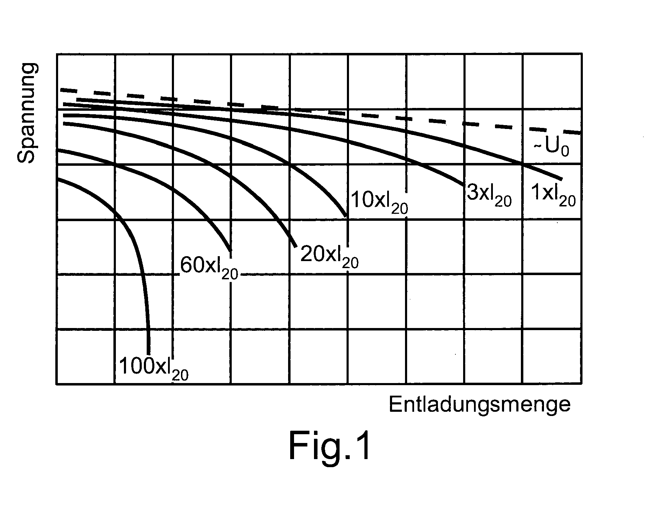

Das in Fig. 1 gezeigte Diagramm zeigt Spannungsverläufe einer Batterie bei Entladung mit verschiedenen Stromstärken bei einer gegebenen Temperatur sowie den ungefähren Verlauf der Ruhespannung U₀.

Der im Diagramm angegebene I₂₀ bedeutet einen 20-stündigen Entladestrom bezogen auf die nominale Kapazität. Wie aus dem Diagramm ersichtlich ist, sinkt mit steigender Stromstärke (=steigendes Vielfaches von I₂₀) die Anfangsspannung (Spannungslage) der Batterie. Gleichzeitig sinkt bei höherer Stromstärke die entnehmbare Strommenge. Eine weitere Abhängigkeit besteht in Bezug auf die Temperatur der Batterie. Hier gilt vereinfacht, dass die Entlademengen geringer und die Batteriespannung niedriger werden, je niedriger die Temperatur ist.

Mit Hilfe dieses Wissens oder durch Messungen kann ein Kennlinienfeld generiert oder erzeugt werden, wobei die einzelnen Kennlinien unter Berücksichtigung der Entladestromstärke, der Temperatur und der entnehmbaren Kapazität der Batterie generiert oder erzeugt werden.

Auf Grundlage des Kennlinienfelds kann unter Betrachtung der Entladestromstärke und der Temperatur der Batteriezustand beurteilt werden. Es kann der aktuelle Zustand der Batterie bewertet werden, es kann eine Abschätzung der entnehmbaren Ladungsmenge und mittels eines Vergleichs des tatsächlichen Spannungsverlaufs mit dem aufgrund der gewählten Kennlinie erwarteten Spannungsverlauf unter Berücksichtigung der tatsächlich entnommenen Ladungsmenge der Alterungszustand der Batterie bewertet werden.

Erfindungsgemäß ist somit keine Bewertung eines Ruhezustandes der Batterie erforderlich.

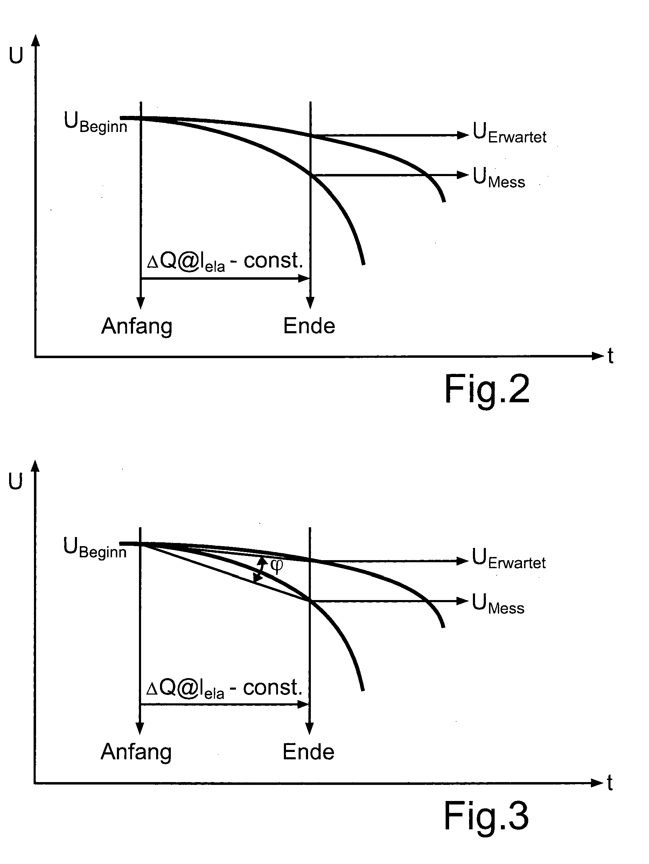

Fig. 2 und Fig. 3 zeigen jeweils ein Diagramm, in dem der tatsächliche Verlauf der Spannung U einer Batterie aufgetragen gegen die Zeit t in Abhängigkeit von der entnommenen Ladungsmenge ΔQ und der erwartete entsprechende Verlauf der Spannung aufgrund der ausgewählten Kennlinie gezeigt sind. Wie aus den Diagrammen zu entnehmen ist, wird hierbei im Verlauf der Zeit t von einer im Wesentlichen konstanten Stromstärke Iₑₗₐ ausgegangen.

Die zu wählende Kennlinie wird erfindungsgemäß aufgrund der Anfangsspannung U_{Beginn} der Batterie, der Entladestromstärke und der Temperatur der Batterie aus dem Kennlinienfeld ausgewählt.

Am Ende des Entladevorgangs wird die Schlussspannung U_{Mess} der Batterie gemessen, und diese Schlussspannung U_{Mess} wird mit der aufgrund der gewählten Kennlinie erwarteten Spannung U_{Erwartet} am Ende der Entladung verglichen. Für den in den Fig. 2 und 3 dargestellten Fall, dass die Schlussspannung U_{Mess} kleiner als die erwartete Spannung U_{Erwartet} am Ende des Entladevorgangs ist, wird festgestellt, dass die tatsächliche Kapazität der Batterie kleiner ist als die am Anfang des Entladevorgangs angenommene entnehmbare Kapazität. ,

Für die Berechnung der tatsächlichen Kapazität bzw. für die Berechnung der Verringerung der tatsächlichen Kapazität im Vergleich zur nominalen, entnehmbaren und/oder verfügbaren Kapazität kann auf bekannte Erfahrungswerte bzw. Berechnungsmethoden zurückgegriffen werden.

Wie in den Fig. 2 und 3 gezeigt, kann in einem zweidimensionalen Koordinatensystem, dem bei Verwendung einer Recheneinheit ein zweidimensionales Datenarray entspricht, die Anfangsspannung U_{Beginn} und die Schlussspannung U_{Mess} der Batterie gegen die Zeit in Abhängigkeit von der entnommenen Ladungsmenge, sowie die erwartete Spannung U_{Erwartet} gegen die Zeit in Abhängigkeit von der entnommenen Ladungsmenge eingetragen werden.

Bei dem erfindungsgemäßen Verfahren wird am Anfang eines Entladevorgangs die Anfangsspannung U_{Beginn} gemessen. Da diese u.a. von der Stärke des Entladestroms abhängig ist, ist "am Anfang" hier so zu verstehen, dass gegebenenfalls eine ausreichende Zeitdauer am Beginn des Entladevorgangs abgewartet werden kann (z.B. 1, 2, 4, 6, 8, 10, 15, 30 Sekunden; 1, 2, 3, 4, 5 Minuten), bis sich eine "stabile" Anfangsspannung eingestellt hat. Wie Fachleuten bekannt ist, hängt die Zeitdauer, bis zu der sich eine "stabile" Anfangsspannung einstellt, derart von der Entlade-Stromstärke ab, dass bei niedrigen Stromstärken (z.B. im Bereich von etwa 1xI₂₀ bis zu etwa 5x I₂₀) eine Zeitdauer im Minutenbereich, und bei hohen Stromstärken (z.B. im Bereich ab etwa 10xI₂₀) eine Zeitdauer von weniger als einer Minute ausreichend ist.

Da während eines Entladevorgangs in der Regel nicht bekannt ist, wann dieser endet, kann selbstverständlich die Spannung der Batterie während eines Entladevorgangs kontinuierlich oder in vorgebbaren Zeitabständen gemessen werden. Wenn dann der Entladevorgang beendet ist, wird die zuletzt während des Entladevorgangs gemessene Spannung als Schlussspannung U_{Mess} verwendet.

Wie in Fig. 2 und 3 dargestellt, kann die ermittelten Differenz zwischen U_{Mess} und U_{Erwartet} unter Berücksichtigung der verwendeten Kennlinie zur Bewertung des Alterungszustands einer Batterie verwendet werden.

Beispielsweise kann, wie dies in Fig. 3 dargestellt ist, die Steigung der Verbindungslinie zwischen der Anfangsspannung U_{Beginn} und der Schlussspannung U_{Mess}, sowie die Steigung der Verbindungslinie zwischen der Anfangsspannung U_{Beginn} und der erwarteten Spannung U_{Erwartet} ermittelt werden, die Differenz der Steigungen der Verbindungslinien oder der Winkel ϕ zwischen den Verbindungslinien ermittelt und zur zur Feststellung der tatsächlichen Kapazität verwendet werden.

Überschreitet beispielsweise der in Fig. 3 gezeigte Winkel ϕ einen vorgebbaren Schwellwert, kann durch die Alterungsbewertung die entnehmbare Kapazität um einen bestimmten Betrag zurückgenommen, bzw. die Berechnung der verfügbaren Kapazität auf Basis einer "kleineren" Batterie durchgeführt werden.

Erfahrungsgemäß sollte die Feststellung der tatsächlichen Kapazität einer Batterie nicht nur auf einer Einzelmessung beruhen, sondern es sollte die Messung mehrere Male, bevorzugt mindestens 5 Mal oder öfter (z.B. 6, 7, 8, 9, 10, 12, 14, 15) in Folge wiederholt werden und eine Bewertung der Abweichung U_{Erwartet} - U_{Mess} oder des Winkels ϕ vorgenommen werden. Hintergrund hierfür ist, dass die zu bestimmenden Größen durch viele Parameter beeinflusst werden können, und durch eine ausreichende Anzahl an Wiederholungen und entsprechende Bewertung der ermittelten Messergebnisse (z.B. Mittelwertbildung) eine ausreichend genaue Annäherung an den tatsächlich gegebenen Alterungszustand der Batterie erreicht werden kann. Allgemein gilt, dass mit einer steigenden Anzahl an Messungen auch die Genauigkeit bei der Beurteilung des Alterungszustands der Batterie zunimmt.

Aus Gründen der Systemstabilität ist es oftmals auch von Vorteil, wenn die festgestellte Verringerung der tatsächlichen Kapazität nicht im vollen Umfang in die Berechnung der nominalen, entnehmbaren und/oder verfügbaren Kapazität eingeht, sondern lediglich eine Adaption in die entsprechende Änderungsrichtung vorgenommen wird. So kann beispielsweise die ermittelte Verringerung der tatsächlichen Kapazität mit einem vorgebbaren Faktor <1 (z.B. 0,9; 0,8; 0,75; 0,6; 0,5) multipliziert und der sich so ergebende Bruchteil der ermittelten Verringerung der tatsächlichen Kapazität für die Bewertung bzw. Berechnung verwendet werden.

Ist das verwendete Kennlinienfeld bzw. die verwendete Kennlinie durch eine mathematische Formel beschrieben, so kann beispielsweise die Größe der nominalen, entnehmbaren ünd/oder verfügbaren Kapazität um ein definiertes Delta zurückgenommen werden.

Die Alterung und damit die Änderung der verfügbaren Kapazität einer Batterie ist keine stochastisch einsetzende sondern eine sich langsam ändernde Größe. Vor diesem Hintergrund können die erfindungsgemäßen Verfahren beispielsweise kontinuierlich, in vorgebbaren Zeitabständen und/oder nach eine vorgebbaren Anzahl an Lade- und Entladevorgängen wiederholt werden.

Das erfindungsgemäße Verfahren ist bei normalen Einsatzzwecken verwendbar, ist einfach anzuwenden, benötigt keine speziellen Testmodi oder -prozeduren, und beruht nicht auf komplizierten Parametern und/oder Modellen. Durch das erfindungsgemäße Verfahren kann somit im laufenden Betrieb auf einfache Weise eine dedizierte Aussage über den aktuellen Energieinhalt einer Batterie gemacht werden. Aufgrund der durch das erfindungsgemäße Verfahren richtig nachgeführten tatsächlichen bzw. korrigierten Batteriekapazität ist auch eine genaue Aussage über die tatsächlich verfügbare Strommenge einer Batterie möglich. Das erfindungsgemäße Verfahren hat weiter den Vorteil, dass es unabhängig von der Zelltechnologie anwendbar ist und keine Ah-Integration erfordert.

## Patentansprüche

1. Verfahren zum Feststellen der tatsächlichen Kapazität einer Batterie im laufenden Betrieb unter Verwendung eines Kennlinienfelds, deren Kennlinien unter Berücksichtigung der Entladestromstärke, der Temperatur und der entnehmbaren Kapazität der Batterie generiert oder erzeugt wurden, wobei
am Anfang eines Entladevorgangs die Anfangsspannung (U_{Beginn}) der Batterie, die Entladestromstärke und die Temperatur der Batterie ermittelt werden,
hieraus durch Vergleich mit den im Kennlinienfeld vorhandenen Daten eine Kennlinie ausgewählt und ein Anfangszustand der Batterie festgelegt werden,
am Ende des Entladevorgangs die Schlussspannung (U_{Mess}) der Batterie gemessen wird,
die Schlussspannung (U_{Mess}) mit der aufgrund der gewählten Kennlinie erwarteten Spannung (U_{Erwartet}) am Ende der Entladung verglichen wird und
für den Fall, dass die Schlussspannung (U_{Mess}) kleiner als die aufgrund des Entladevorgangs erwartete Spannung (U_{Erwartet}) ist, festgestellt wird, dass die tatsächliche Kapazität der Batterie kleiner ist als die am Anfang des Entladevorgangs angenommene entnehmbare Kapazität.

2. Verfahren nach Anspruch 1, wobei
die Feststellung der tatsächlichen Kapazität der Batterie erfolgt, indem die Schritte gemäß Anspruch 1 in der angegebenen Reihefolge mehrere Male in Folge wiederholt und eine Bewertung der ermittelten Differenz zwischen der Schlussspannung (U_{Mess}) und der erwarteten Spannung (U_{Erwartet}) durchgeführt werden.

3. Verfahren nach Anspruch 2, wobei
die Feststellung der tatsächlichen Kapazität der Batterie erfolgt, nachdem die Schritte gemäß Anspruch 1 wenigstens 5 Mal in Folge durchgeführt wurden.

4. Verfahren nach einem der vorhergehenden Ansprüche, wobei in einem zweidimensionalen Koordinatensystem die Anfangsspannung (U_{Beginn}) und die Schlussspannung (U_{Mess}) der Batterie gegen die Zeit in Abhängigkeit von der entnommenen Ladungsmenge, sowie die erwartete Spannung (U_{Erwartet}) gegen die Zeit in Abhängigkeit von der entnommenen Ladungsmenge eingetragen werden, die Steigung der Verbindungslinie zwischen der Anfangsspannung (U_{Beginn}) und der Schlussspannung (U_{Mess}), sowie die Steigung der Verbindungslinie zwischen der Anfangsspannung (U_{Beginn}) und der erwarteten Spannung (U_{Erwartet}) ermittelt werden, die Differenz der Steigungen der Verbindungslinien oder der Winkel zwischen den Verbindungslinien (ϕ) ermittelt und zur Feststellung der nominalen, entnehmbaren, verfügbaren und/oder tatsächlichen Kapazität verwendet werden.

5. Verfahren nach einem der vorhergehenden Ansprüche, wobei für den Fall, dass die Feststellung der tatsächlichen Kapazität eine im Vergleich zu einer neuwertigen Batterie verringerte tatsächliche Kapazität ergeben hat, eine verringerte nominale, entnehmbare, verfügbare und/oder tatsächliche Kapazität in einer Speichereinrichtung gespeichert wird/werden.

6. Verfahren nach einem der vorhergehenden Ansprüche, wobei für den Fall, dass die Feststellung der tatsächlichen Kapazität eine im Vergleich zu einer neuwertigen Batterie verringerte tatsächliche Kapazität ergeben hat, bei einem durch eine mathematische Formel beschriebenen Kennlinienfeld oder einer durch eine mathematische Formel beschriebenen Kennlinie die Größe der nominalen, entnehmbaren und/oder verfügbaren Kapazität um ein vorgebbaren Wert zurückgenommen wird.

7. Verfahren nach einem der Ansprüche 5 oder 6, wobei die ermittelte Verringerung der tatsächlichen Kapazität nicht im vollen Umfang für die Bewertung der nominalen, entnehmbaren und/oder verfügbaren Kapazität verwendet wird.

8. Vorrichtung zum Feststellen der tatsächlichen Kapazität einer Batterie im laufenden Betrieb mit einer Speichereinrichtung, einer Spannungsmesseinrichtung, einer Strommesseinrichtung, einer Temperaturmesseinrichtung und einer Recheneinheit und einem darin ausführbaren Computerprogramm, wobei
die Speichereinrichtung dazu eingerichtet ist, wenigstens ein Kennlinienfeld einer Batterie zu speichern bzw. darin gespeichert zu haben, wobei die Kennlinien des Kennlinienfelds unter Berücksichtigung der Entladestromstärke, der Temperatur und der entnehmbaren Kapazität der Batterie generiert oder erzeugt wurden,
die Spannungsmesseinrichtung dazu eingerichtet ist, wenigstens eine Anfangsspannung (U_{Beginn}) der Batterie am Anfang und eine Schlussspannung (U_{Mess}) der Batterie am Ende eines Entladevorgangs zu messen,
die Strommesseinrichtung dazu eingerichtet ist, wenigstens die Stärke eines Entladestroms der Batterie zu messen,
die Temperaturmesseinrichtung dazu eingerichtet ist, die Temperatur von wenigstens einer Batteriekomponente zu messen, und
die Recheneinheit mit dem darauf ablaufenden Computerprogramm dazu eingerichtet ist, unter Berücksichtigung der Anfangsspannung (U_{Beginn}), der Schlussspannung (U_{Mess}) und der aufgrund der gewählten Kennlinie erwarteten Spannung (U_{Erwartet}) die tatsächliche Kapazität der Batterie festzustellen, derart, dass für den Fall, dass die Schlussspannung (U_{Mess}) kleiner als die aufgrund des Entladevorgangs erwartete Spannung (U_{Erwartet}) ist, festgestellt wird, dass die tatsächliche Kapazität der Batterie kleiner ist als die am Anfang des Entladevorgangs angenommene entnehmbare Kapazität.

9. Vorrichtung nach Anspruch 8, die dazu eingerichtet ist, eines der Verfahren gemäß den Ansprüchen 2 bis 7 durchzuführen.

## Claims

1. A method for determining an actual capacity of a battery during ongoing operation, using a characteristic curve field having characteristic curves generated by taking into account a magnitude of a discharge current, a temperature and a removable capacity of a battery, the method comprising the steps of:
determining at a start of a discharge process an initial voltage (U_{Beginn}) of the battery, a magnitude of the discharge current and a temperature of the battery, by comparison of the magnitude of the discharge current and the temperature with data contained in the characteristic curve field, selecting a characteristic curve and determining an initial state of the battery,
measuring a final voltage (U_{Mess}) of the battery at an end of the discharge process, comparing the final voltage (U_{Mess}) with an expected voltage (U_{Erwartet}) expected at the end of the discharge process based on the selected characteristic curve, and
when the final voltage (U_{Mess}) is smaller than the expected voltage (U_{Erwartet}) expected based on the discharge process, concluding that the actual capacity of the battery is smaller than the removable capacity assumed at the beginning of the discharge process.

2. The method according to claim 1, wherein
the actual capacity of the battery is determined by repeating the steps of claim 1 several times in the specified sequential order and by assessing a determined difference between the final voltage (U_{Mess}) and the expected voltage(U_{Erwartet}).

3. The method according to claim 2, wherein
the actual capacity of the battery is determined by repeating the steps of claim 1 at least 5 times.

4. The method according to any of the preceding claims, comprising entering the initial voltage (U_{Beginn}) and the final voltage (U_{Mess}) of the battery as a function of time and in dependence of the removed amount of charge in a two-dimensional coordinate system, and entering the expected voltage (U_{Erwartet}) as a function of time and in dependence of the removed amount of charge in a two-dimensional coordinate system, determining a slope of a connecting line between the initial voltage (U_{Beginn}) and the final voltage (U_{Mess}) as well as a slope of a connecting line between the initial voltage (U_{Beginn}) and the expected voltage (U_{Erwartet}), determining a difference of the slopes of the connecting lines or an angle between the connecting lines (ϕ), for determining a nominal, removable, available and/or actual capacity.

5. The method according to any of the preceding claims, wherein when the determined actual capacity is smaller than an actual capacity of a new battery, a reduced nominal, removable, available and/or actual capacity is stored in a memory device.

6. The method according to any of the preceding claims, wherein
when the determined actual capacity is smaller than an actual capacity of a new battery, the nominal, removable and/or available capacity is reduced by a specifiable value when the characteristic curve field or the characteristic curve is described by a mathematical formula.

7. The method according to any of claims 5 or 6, wherein the nominal, removable and/or available capacity is reduced by less than the full specifiable value.

8. A device for determining the actual capacity of a battery during ongoing operation, the device comprising a memory device, a voltage measuring device, a current measuring device, a temperature measuring device and a computing device having a computer program executable thereon, wherein
the memory device is configured to store or have stored therein at least one characteristic curve field of a battery, a characteristic curve field having characteristic curves generated by taking into account a magnitude of a discharge current, a temperature and a removable capacity of the battery,
the voltage measuring device is configured to measure at least an initial voltage (U_{Beginn}) of the battery at the beginning of a discharge process and a final voltage (U_{Mess}) of the battery at the end of the discharge process,
the current measuring device is configured to measure at least a magnitude of the discharge current of the battery,
the temperature measuring device is configured to measure the temperature of at least one battery component, and
the computing device having a computer program executable thereon is configured to determine an actual capacity of the battery by taking into account the initial voltage (U_{Beginn}), the final voltage (U_{Mess}) and an expected voltage (U_{Erwartet}) expected based on a selected characteristic curve, such that when the final voltage (U_{Mess}) is smaller than the expected voltage (U_{Erwartet}) expected based on the discharge process, it is concluded that the actual capacity of the battery is smaller than a removable capacity assumed at the beginning of the discharge process.

9. The device according to claim 8, configured to carry out a method according to any of claims 2 to 7.

## Revendications

1. Procédé de détermination de la capacité réelle d'une batterie en cours de fonctionnement en utilisant un réseau de caractéristiques dont les caractéristiques ont été générées ou produites en tenant compte de l'intensité de courant de décharge, de la température et de la capacité pouvant être prélevée de la batterie,
selon lequel, au début d'une opération de décharge, on détermine la tension initiale (U_{Beginn}) de la batterie, l'intensité de courant de décharge et la température de la batterie,
selon lequel, à partir de là, en comparant avec les données présentes dans le réseau de caractéristiques, on choisit une courbe caractéristique et on fixe un état initial de la batterie,
selon lequel, à la fin de l'opération de décharge, on mesure la tension finale (U_{Mess}) de la batterie,
selon lequel on compare la tension finale (U_{Mess}) à la tension (U_{Erwartert}) escomptée d'après la courbe caractéristique choisie à la fin de la décharge et
selon lequel, si la tension finale (U_{Mess}) est inférieure à la tension (U_{Erwartert}) escomptée en raison de l'opération de décharge, on détermine que la capacité réelle de la batterie est inférieure à la capacité supposée pouvant être prélevée au début de l'opération de décharge.

2. Procédé selon la revendication 1, **caractérisé en ce que** la détermination de la capacité réelle de la batterie s'effectue en répétant plusieurs fois successivement les étapes selon la revendication 1 dans l'ordre indiqué et en effectuant une évaluation de la différence déterminée entre la tension finale (U_{Mess}) et la tension escomptée (U_{Erwartert}).

3. Procédé selon la revendication 2, selon lequel la détermination de la capacité réelle de la batterie s'effectue après que les étapes selon la revendication 1 ont été exécutées 5 fois successivement.

4. Procédé selon l'une des revendications précédentes, selon lequel, dans un système de coordonnées à deux dimensions, on enregistre la tension initiale (U_{Beginn}) et la tension finale (U_{Mess}) de la batterie par rapport au temps en fonction de la quantité de charge prélevée ainsi que la tension escomptée (U_{Erwartert}) par rapport au temps en fonction de la quantité de charge prélevée, on détermine la pente de la ligne de jonction entre la tension initiale (U_{Beginn}) et la tension finale (U_{Mess}) ainsi que la pente de la ligne de jonction entre la tension initiale (U_{Beginn}) et la tension escomptée (U_{Erwartert}), on détermine la différence des pentes de lignes de jonction ou l'angle entre les lignes de jonction (φ) et on l'utilise pour déterminer la capacité nominale, pouvant être prélevée, disponible et/ou réelle.

5. Procédé selon l'une des revendications précédentes, **caractérisé en ce que**, si la détermination de la capacité réelle a donné une capacité réelle réduite en comparaison d'une batterie à l'état neuf, on mémorise dans une mémoire une capacité nominale, pouvant être prélevée, disponible et/ou réelle, réduite.

6. Procédé selon l'une des revendications précédentes, **caractérisé en ce que**, si la détermination de la capacité réelle a donné une capacité réelle réduite en comparaison d'une batterie à l'état neuf, on soustrait de la grandeur de la capacité nominale, pouvant être prélevée et/ou disponible une valeur prescriptible pour un réseau de caractéristiques décrit par une formule mathématique ou pour une courbe caractéristique décrite par une formule mathématique.

7. Procédé selon l'une des revendications 5 ou 6, **caractérisé en ce que** l'on n'utilise pas intégralement la réduction déterminée de la capacité réelle pour évaluer la capacité nominale, pouvant être prélevée et/ou disponible.

8. Dispositif pour déterminer la capacité réelle d'une batterie en cours de fonctionnement avec une mémoire, un dispositif de mesure de tension, un dispositif de mesure de courant, un dispositif de mesure de température et une unité de calcul ainsi qu'un programme informatique exécutable sur celle-ci,
la mémoire étant conçue pour mémoriser ou avoir mémorisé au moins un réseau de caractéristiques d'une batterie,
les courbes caractéristiques du réseau de caractéristiques ayant été générées ou produites en tenant compte de l'intensité de courant de décharge, de la température et de la capacité pouvant être prélevée de la batterie,
le dispositif de mesure de tension étant conçu pour mesurer au moins une tension initiale (U_{Beginn}) de la batterie au début et une tension finale (U_{Mess}) de la batterie à la fin d'une opération de décharge,
le dispositif de mesure de courant étant conçu pour mesurer au moins l'intensité d'un courant de décharge de la batterie,
le dispositif de mesure de température étant conçu pour mesurer la température d'au moins un composant de batterie, et
l'unité de calcul avec le programme informatique exécuté sur celle-ci étant conçue pour déterminer la capacité réelle de la batterie en tenant compte de la tension initiale (U_{Beginn}), de la tension finale (U_{Mess}) et de la tension (U_{Erwartert}) escomptée d'après la courbe caractéristique choisie de telle sorte que, si la tension finale (U_{Mess}) est inférieure à la tension (U_{Erwartert}) escomptée en raison de l'opération de décharge, on détermine que la capacité réelle de la batterie est inférieure à la capacité supposée pouvant être prélevée au début de l'opération de décharge.

9. Dispositif selon la revendication 8, qui est conçu pour réaliser l'un des procédés selon les revendications 2 à 7.
